# EUROPEAN PATENT APPLICATION

(11) **EP 2 224 498 A2**
(43) Date of publication of application: **01.09.2010**
(21) Application number: 10001896.9
(22) Date of filing: 24.02.2010
(51) Int. Cl.: H01L 31/167

(54) **Photo-coupler with high operating voltage**

(30) Priority: 27.02.2009 TW 098106353
(71) Applicant: Everlight Electronics Co., Ltd., Tucheng City / Taipei County (TW)
(72) Inventor: Su, Chao-Hsuan, Tucheng City Taipei County (TW); Lai, Lu-Ming, Tucheng City Taipei County (TW); Chen, Ying-Zhong, Tucheng City Taipei County (TW)
(74) Representative: Michalski Hüttermann & Partner Patentanwälte

(57) **Abstract**

A photo-coupler having a high operating voltage is provided. The photo-coupler comprises a light emitting chip (22), a light-sensing chip (23), a light-transmissive inner encapsulant package (25) and an outer package (26). Both the light emitting chip (22) and the light-sensing chip (23) face the same direction, while the light-sensing chip (23) receives a light beam emitted by the light emitting chip (22). The light-transmissive inner encapsulant package (25) encloses the light emitting chip (22) and the light-sensing chip (23), while the outer package (26) encloses the light-transmissive inner encapsulant package (25). An interface (28) is formed between the light-transmissive inner encapsulant package (25) and the outer package (26) for reflecting the light beam. A reflective curve surface adjacent to the light emitting chip (22) is formed on the interface (28) of the light-transmissive inner encapsulant package (25) for reflecting and converging the first portion of the light beam to the light-sensing chip (23).

## Description

This application claims priority to Taiwan Patent Application No. 098106353 filed on February 27, 2009, the disclosure of which is incorporated by reference.

### CROSS-REFERENCES TO RELATED APPLICATIONS

### BACKGROUND OF THE INVENTION

### Field of the Invention

The present invention relates to a photo-coupler, and particularly, to a photo-coupler having a high operating voltage.

### Descriptions of the Related Art

Photo-couplers are circuit safety devices which, when combined with a light emitting chip and a photo sensing chip, convert an electric signal into a light signal and then convert the light signal back into an electric signal. Photo-couplers can obviate bursts and other instable conditions from the source end and prevent consequent burning-out or failure of circuits at the receiving end when the electrical connection is made simply via a circuit.

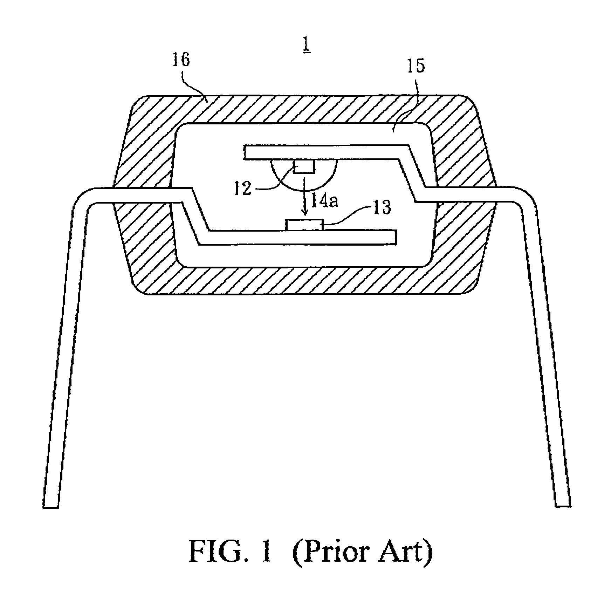

As shown in **FIG 1****,** a conventional photo-coupler **1** comprises a light emitting chip **12** and a light-sensing chip **13** opposite each other in the vertical direction. The light emitting chip **12** and the light-sensing chip **13** are enclosed by an inner package **15,** which is made of an insulator to electrically insulate the light emitting chip **12** and the light-sensing chip **13** from each other. The inner package **15** is in turn enclosed by an opaque outer package **16,** which generally has a black color adapted to block and absorb light from both the inside and the outside. When an input electric signal is transmitted to the light emitting chip **12**, the light emitting chip **12** converts the input electric signal into a light beam 14a, and the light beam **14a** is then received by the light-sensing chip **13** where it is converted into an output electric signal. Thus, the conventional photo-coupler **1** accomplishes a cycle of electric signal/light signal conversion and light signal/electric signal conversion to play the role of a circuit safety device.

To block light from both inside and outside of the outer package **16,** a large amount of filler must be filled in the plastic matrix to give it a black color. However, use of the filler changes the thermal expansion coefficient of the outer package **16** to a great extent. Therefore, an appropriate amount of filler must also be filled in the inner package **15** to make the thermal expansion coefficient of the inner package **15** approximately that of the outer package **16,** so that an undue temperature rise and consequent deformation or damage of the inner package **15** and the outer package **16** due to a large difference in the thermal expansion coefficients therebetween can be avoided. Because of this, the inner package **15** is generally white colored and forced to have a low light transmittance. However, the low light transmittance of the inner package **15** further prevents the distance between the light emitting chip **12** and the light-sensing chip **13** from increasing, otherwise the light beam **14a** from the light emitting chip **12** would experience an excessive loss when transmitting through the inner package **15** and the light-sensing chip **13** would fail to receive sufficient light that is necessary for converting the light signal into an electric signal.

Furthermore, the conventional photo-coupler **1** has an insulation voltage (V_{ISO}) substantially less than or equal to 5000 V, so the light emitting chip **12** and the light-sensing chip 13 must have a minimum distance at least ranging substantially from 0.4 mm to 0.6 mm to avoid point discharge. However, in case the operating voltage needs to be substantially higher than 8000 V, the minimum distance between the light emitting chip **12** and the light-sensing chip **13** must be substantially greater than 3.0 mm and the creepage distance must be substantially greater than 8.0 mm according to the safety regulations. Under such operating conditions, due to the extremely low light transmittance of the inner package **15,** the light beam **14a** emitted from the light emitting chip **12** would experience such an excessive loss that the light-sensing chip **13** might fail to convert the light signal into the electric signal normally, causing failure of the photo-coupler **1** to operate under such conditions.

It is important in the art to provide a photo-coupler capable of operating at a high voltage.

### SUMMARY OF THE INVENTION

One objective of the present invention is to provide a photo-coupler capable of operating at a high voltage and obviating an excessive light loss that would cause operational failure of the photo-coupler.

The photo-coupler of the present invention comprises a light emitting chip, a light-sensing chip, a light-transmissive inner encapsulant package and an outer package. Both the light emitting chip and the light-sensing chip face towards a same direction, and are adapted to emit and receive a light beam respectively. The light-transmissive inner encapsulant package encloses the light emitting chip and the light-sensing chip, while the outer package encloses the light-transmissive inner encapsulant package and forms an interface with the light-transmissive inner encapsulant package for reflecting the light beam. The light-transmissive inner encapsulant package is formed with a reflective curved surface adjacent to the light emitting chip which, as enclosed by the outer package, is adapted to reflect and converge a first portion of the light beam to the light-sensing chip.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG. 1** is a schematic cross-sectional side view of the conventional photo-coupler;
**FIG. 2** is a schematic cross-sectional bottom view of a photo-coupler of the present invention;
**FIG. 3** is a schematic cross-sectional side view of the photo-coupler of the present invention; and
**FIG. 4** is a schematic perspective view of a light-transmissive inner encapsulant package of the present invention.

### DESCRIPTION OF THE PREFERRED EMBODIMENT

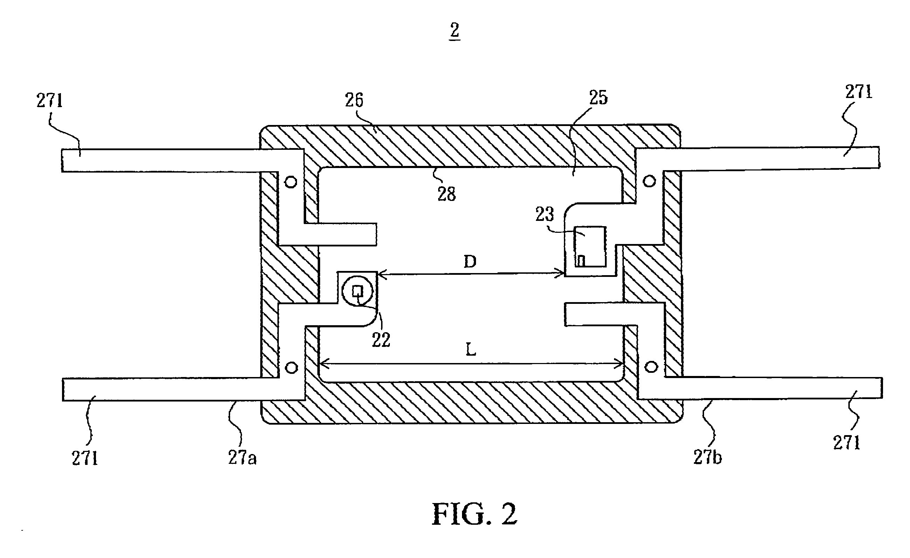

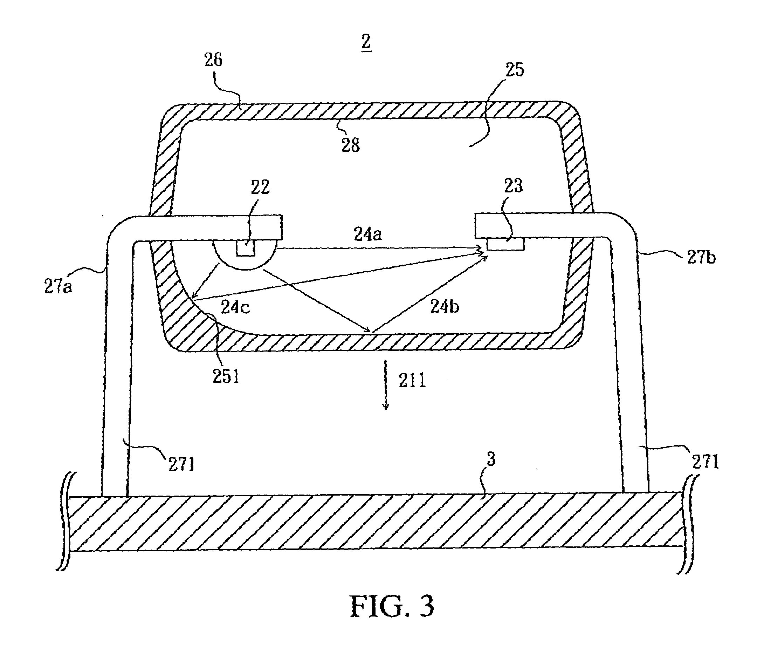

In references to both **FIGS. 2** and **3****,** a photo-coupler **2** disclosed in the present invention comprises a light emitting chip **22,** a light-sensing chip **23,** a light-transmissive inner encapsulant package **25** and an outer package **26**. The light emitting chip **22** and the light-sensing chip **23** both are disposed in a same plane and face towards a same direction **211** of the photo-coupler **2.**

The light emitting chip **22,** after receiving an input electric signal, is adapted to generate and emit a first portion **24c**, a second portion **24b** and a third portion **24a** of a light beam. After receiving the first portion **24c**, the second portion **24b** and the third portion **24a** of the light beam, the light-sensing chip **23** converts them into an output electric signal and transmits the signals. The light-transmissive inner encapsulant package **25** encloses the light emitting chip **22** and the light-sensing chip **23,** while the outer package **26** encloses the light-transmissive inner encapsulant package **25.** With an interface **28** formed between the light-transmissive inner encapsulant package **25** and the white outer package **26,** the outer package **26** reflects the first portion **24c**, the second portion **24b** and the third portion **24a** of the light beam to the light-sensing chip **23** through the light-transmissive inner encapsulant package **25.**

In the present invention, the light emitting chip **22** should be an infrared light emitting diode (IR LED), while the light-sensing chip **23** is a photo transistor. The material of the light-transmissive inner encapsulant package **25** preferably comprises epoxy resin, and to enhance the reflectivity, the material of the outer package **26** should preferably comprise an epoxy resin matrix and white TiO₂ filler. Hence, with the above arrangement, the light-transmissive inner encapsulant package **25** encloses the light emitting chip **22** and the light-sensing chip **23,** while the outer package **26** in turn encloses the light-transmissive inner encapsulant package **25**. The white outer package **26** can effectively reflect the first portion **24c,** the second portion **24b** and the third portion **24a** of the light beam from the light emitting chip **22** to the light-sensing chip **23**. As compared to the light beam **14a** in the conventional photo-coupler 1 which is transmitted through the white inner package **15,** the first portion **24c**, the second portion **24b** and the third portion **24a** of the light beam in the present invention are transmitted through the light-transmissive inner encapsulant package **25** with little loss between the light emitting chip **22** and the light-sensing chip **23**. As a result, the distance **D** between the light emitting chip **22** and the light-sensing chip **23** is permitted to be enlarged to reinforce the insulation capability of the light-transmissive inner encapsulant package **25,** thereby allowing the photo-coupler **2** of the present invention to withstand a higher operating voltage.

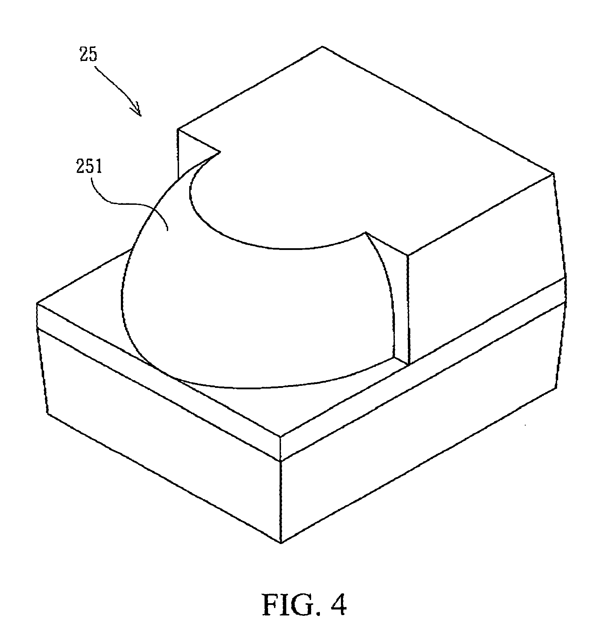

As shown in **FIGS. 3** and **4****,** to further increase the efficiency of transmitting the first portion **24c**, the second portion **24b** and the third portion **24a** of the light beam from the light emitting chip **22** through the light-transmissive inner encapsulant package **25** to the light-sensing chip **23,** the light-transmissive inner encapsulant package **25** is formed with a reflective curved surface **251** adjacent to the light emitting chip **22** for reflecting and converging the first portion **24c** of the light beam to the light-sensing chip **23**. In the most preferred embodiment of the present invention, the reflective curved surface **251** is disposed adjacent to the light emitting chip **22** and at a side opposite the light-sensing chip **23** with respect to the light emitting chip **22;** i.e., the light emitting chip **22** is disposed between the light-sensing chip **23** and the reflective curved surface **251.** When enclosed by the outer package **26,** the reflective curved surface **251** is adapted to reflect and converge the first portion **24c** of the light beam to the light-sensing chip **23.**

In addition to the first portion **24c** of the light beam being reflected and converged by the reflective curved surface **251** to the light-sensing chip **23,** as shown in **FIG. 3****,** the third portion **24a** of the light beam transmits linearly through the light-transmissive inner encapsulant package **25** from the light emitting chip **22** to the light-sensing chip **23** directly as shown, and the second portion **24b** of the light beam is reflected by the outer package **26** through the light-transmissive inner encapsulant package **25** to the light-sensing chip **23.** Thereby, the photo-coupler **2** of the present invention can utilize the light beam emitted from the light emitting chip **22** in a more efficient way, which allows to further increase the minimum distance **D** between the light emitting chip **22** and the light-sensing chip **23** and enable the photo-coupler **2** of the present invention to withstand a higher operating voltage.

In the most preferred embodiment of the present invention, the photo-coupler **2** is mounted with the direction **211** facing towards a circuit board **3** (i.e., both the light emitting chip **22** and the light-sensing chip **23** face towards the underside of the photo-coupler **2**) to completely eliminate the effect of environmental light transmitted through the white outer package **26** on the light-sensing chip **23.** Additionally, at least two lead frames **27a, 27b** of the photo-coupler **2** of the present invention extend outward away from each other, with a plurality of pins **271** thereof extending also downwards to electrically connect with the circuit board **3.** The light emitting chip **22** and the light-sensing chip **23** are disposed on the first lead frame **27a** and the second lead frame **27b** respectively to allow the light emitting chip **22** to receive the input electric signal and the light-sensing chip **23** to transmit the output electric signal. As will be readily appreciated by those of ordinary skill in the art, the first lead frame **27a** and the second lead frame **27b** may also extend towards a same direction instead.

In reference to **FIG. 2****,** to enable the photo-coupler **2** of the present invention to operate at a high operating voltage that is substantially higher than 8000 V, the light emitting chip **22** and the light-sensing chip **23** are disposed adjacent to the two ends of a long edge **L** of the light-transmissive inner encapsulant package **25** respectively. As a consequence, the minimum distance **D** between the light emitting chip **22** and the light-sensing chip **23** may be substantially greater than or equal to 3.0 mm, and the creepage distance thereof is substantially greater than 8.0 mm. Correspondingly, the reflective curved surface **251** is disposed at the end of the long edge **L** of the light-transmissive inner encapsulant package **25** adjacent to the light emitting chip **22**. Accordingly, by increasing the distance between the light emitting chip **22** and the light-sensing chip **23,** the photo-coupler **2** of the present invention is adapted to operate at a high operating voltage and prevent point discharge. Moreover, due to the disposition of the light-transmissive inner encapsulant package 25, the outer package **26** and the reflective curved surface **251**, the transmission efficiency of the first portion **24c**, the second portion **24b** and the third portion **24a** of the light beam will not decrease as the distance between the light emitting chip **22** and the light-sensing chip **23** increases.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A photo-coupler, comprising:
a light emitting chip facing a direction disposed, for emitting a light beam;
a light-sensing chip facing the direction disposed, for receiving the light beam;
a light-transmissive inner encapsulant package enclosing the light emitting chip and the light-sensing chip; and
an outer encapsulant package enclosing the light-transmissive inner encapsulant package and forming an interface with the light-transmissive inner encapsulant package for reflecting the light beam;
wherein the interface has a reflective curved surface adjacent to the light emitting chip for reflecting and converging a first portion of the light beam from the light emitting chip to the light-sensing chip.

2. The photo-coupler as claimed in claim 1, wherein the reflective curved surface is disposed on a side opposite to the light-sensing chip with regard to the light emitting chip.

3. The photo-coupler as claimed in claim 1 or 2, wherein the light emitting chip and the light-sensing chip are disposed on the same plane.

4. The photo-coupler as claimed in any of claims 1 to 3, wherein the interface comprises a reflective surface between the light emitting chip and the light-sensing chip for reflecting a second portion of the light beam emitting from the light emitting chip to the light-sensing chip, and a third portion of the light beam emitting from the light emitting chip transmits through the light-transmissive inner encapsulant package to the light-sensing chip directly.

5. The photo-coupler as claimed in any of claims 1 to 4, wherein the photo-coupler further comprises at least two lead frames, the light emitting chip and the light-sensing chip are disposed on the lead frames respectively, and the at least two lead frames extend outward away from each other.

6. The photo-coupler as claimed in any of claims 1 to 4, wherein the photo-coupler further comprises at least two lead frames, the light emitting chip and the light-sensing chip are disposed on the lead frames respectively, the at least two lead frames extend outward in the same direction.

7. The photo-coupler as claimed in any of claims 1 to 6, wherein the material of the light-transmissive inner encapsulant package comprises epoxy resin.

8. The photo-coupler as claimed in any of claims 1 to 7, wherein the material of the outer package comprises epoxy resin matrix and white filler, and the white filler comprises TiO₂.

9. A photo-coupler, comprising:
a light emitting chip disposed on a first lead frame for emitting a light beam;
a light-sensing chip disposed on a second lead frame for receiving the light beam, in which the light emitting chip and the light-sensing chip face a same direction and are disposed on a same plane;
a light-transmissive inner encapsulant package enclosing the light emitting chip and the light-sensing chip; and
an outer package enclosing the light-transmissive inner encapsulant package and forming an interface with the light-transmissive inner encapsulant package for reflecting the light beam;
wherein the interface has a reflective curved surface adjacent to the light emitting chip for reflecting and converging a first portion of the light beam emitting from the light emitting chip to the light-sensing chip.

10. The photo-coupler as claimed in claim 9, wherein the reflective curved surface is disposed on a side opposite to the light-sensing chip with regard to the light emitting chip.

11. The photo-coupler as claimed in claim 9 or 10, wherein the interface comprises a reflective surface between the light emitting chip and the light-sensing chip for reflecting a second portion of the light beam emitting from the light emitting chip to the light-sensing chip.

12. The photo-coupler as claimed in any of claims 9 to 11, wherein the first lead frame and the second lead frame extend outward away from each other or extend in a same direction.

13. A photo-coupler, comprising:
a light emitting chip emitting a light beam;
a light-sensing chip receiving the light beam; and
a light-transmissive inner encapsulant package enclosing the light emitting chip and the light-sensing chip;
wherein the surface of the light-transmissive inner encapsulant package adjacent to the light emitting chip is formed with a reflective curved surface for reflecting and converging a first portion of the light beam emitting from the light emitting chip to the light-sensing chip.

14. The photo-coupler as claimed in claim 13, wherein the reflective curved surface is disposed on a side opposite to the light-sensing chip with regard to the light emitting chip.
